# EUROPÄISCHE PATENTANMELDUNG

(11) **EP 0 859 237 A1**
(43) Veröffentlichungstag der Anmeldung: **19.08.1998**
(21) Anmeldenummer: 98101931.8
(22) Anmeldetag: 04.02.1998
(51) Int. Cl.: G01R 27/06, H04B 17/00, H04Q 7/34

(54) **Verfahren und Vorrichtung zur Inspektion wenigstens eines Antennenzweigs, insbesondere in einem Fahrzeug**

(30) Priorität: 14.02.1997 DE 19705735
(71) Anmelder: NOKIA MOBILE PHONES LTD., 02150 Espoo (FI)
(72) Erfinder: Pietsch, Andreas, 45721 Haltern (DE); Dalisda, Uwe, 45279 Essen (DE); Karhu, Jukka-Matti, 45879 Gelsenkirchen (DE); Hess, Jürgen, 44869 Bochum (DE); Christiansen, Holger, 44787 Bochum (DE)
(74) Vertreter: TER MEER STEINMEISTER & PARTNER GbR

(57) **Zusammenfassung**

Zur Inspektion wenigstens eines Antennenzweigs (A1, A2, ..., An), insbesondere in einem Fahrzeug, wird zunächst in den Antennenzweig eine abzustrahlende Leistung eingespeist, wonach eine im Antennenzweig reflektierte Leistung erfaßt wird. Sodann werden die eingespeiste Leistung und die reflektierte Leistung zueinander in Beziehung gesetzt, um ein die Güte des Antennenzweigs angebendes Qualitätssignal zu erhalten. Dieser Vorgang kann bei mehreren Antennenzweigen nacheinander durchgeführt werden, um in Abhängigkeit des jeweiligen Qualitätssignals denjenigen Antennenzweig auszuwählen, bei dem die reflektierte Leistung am kleinsten ist. Damit lassen sich einerseits die Anpassungen der Antennenzweige überprüfen, während andererseits dafür gesorgt werden kann, daß z. B. bei Beschädigung bestimmter Antennenzweige immer andere für eine einwandfreie Kommunikation herausgesucht werden können.

## Beschreibung

Die Erfindung betrifft ein Verfahren zur Inspektion wenigstens eines Antennenzweigs, insbesondere in einem Fahrzeug, gemäß dem Anspruch 1 sowie eine Vorrichtung zur Durchführung des Verfahrens gemäß dem Anspruch 14.

Heutzutage werden in zunehmenden Maße Telefone in Fahrzeuge eingebaut, und zwar entweder nachträglich durch den Kunden selbst oder schon bei der Produktion der Fahrzeuge, bei denen es sich z. B. um Kraftfahrzeuge handeln kann. So ist z. B. der Einbau von zwei Koaxialleitungen für GSM (Global System for Mobile Communications) Antennen möglich, die als normale oder Notfallantennen arbeiten können. Beim Einbau oder während des späteren Betriebs der Kraftfahrzeuge besteht allerdings die Gefahr, daß die Koaxialleitungen, die Stecker oder die Antennen selbst beschädigt werden. Eine einwandfreie Kommunikation über diese Antennen ist dann nur noch schwer oder überhaupt nicht mehr möglich. Entsprechende Probleme können auch in Antennenzweigen von Global Positioning Systemen (GPS) auftreten.

Der Erfindung liegt die Aufgabe zugrunde, ein Verfahren und eine Vorrichtung zu schaffen, um Antennenzweige besser auf ihre Betriebszuverlässigkeit überprüfen zu können.

Eine verfahrensseitige Lösung der gestellten Aufgabe ist im Anspruch 1 angegeben. Dagegen findet sich eine vorrichtungsseitige Lösung der gestellten Aufgabe im Anspruch 6. Vorteilhafte Ausgestaltungen der Erfindung sind den jeweils nachgeordneten Unteransprüchen zu entnehmen.

Ein erfindungsgemäßes Verfahren zur Inspektion wenigstens eines Antennenzweigs, insbesondere in einem Fahrzeug, umfaßt folgende Schritte: in den Antennenzweig wird eine abzustrahlende Leistung eingespeist; eine im Antennenzweig reflektierte Leistung wird erfaßt; und es werden die eingespeiste Leistung und die reflektierte Leistung zueinander in Beziehung gesetzt, um ein die Güte des Antennenzweigs angebendes Qualitätssignal zu erhalten. Dabei können zur Bildung des Qualitätssignals die eingespeiste Leistung und die reflektierte Leistung auch zueinander ins Verhältnis gesetzt werden.

Je nach dem, ob wenig oder viel reflektierte Leistung erfaßt wird, läßt sich das Qualitätssignal als gut oder schlecht einstufen. Liegt die reflektierte Leistung unterhalb eines vorbestimmten Pegels, so wird der überprüfte Antennenzweig zur Kommunikation bereitgestellt. Überschreitet dagegen die reflektierte Leistung einen vorbestimmten Pegel, so wird der überprüfte Antennenzweig für die weitere Kommunikation gesperrt. Dies erfolgt nicht zuletzt auch aus dem Grunde, die Leistungsendstufe des Senders vor Beschädigung zu schützen, also insbesondere den HF-Endverstärker.

Das erfindungsgemäße Verfahren kann zu allen geeigneten Zeitpunkten angewandt werden, beispielsweise bei jeder neuen Inbetriebnahme eines mit dem Antennenzweig verbundenen Kommunikationssystems, periodisch oder zu irgendwelchen anderen geeigneten Zeitpunkten, zu denen dies durch das Kommunikationssystem zugelassen wird.

Nach einer sehr vorteilhaften Ausgestaltung der Erfindung werden die abzustrahlende Leistung und die reflektierte Leistung mit Hilfe eines im Antennenzweig vorhandenen bidirektionalen Meßrichtkopplers erfaßt.

Derartige Meßrichtkoppler sind allgemein bekannt und lassen sich in einfacher Weise mit dem HF-Sender ausgangsseitig verbinden. Die aus dem Meßrichtkoppler ausgekoppelten vorlaufenden und rücklaufenden Wellen können dann z. B. gleichgerichtet werden, um den jeweils ausgekoppelten Leistungen proportionale Gleichspannungen zur Verfügung zu stellen, die z. B. zur Ermittlung eines Stehwellenverhältnisses (VSWR) dienen können, welches als Qualitätssignal weiterverwendet wird. Die genannten Gleichspannungen können zunächst aber auch jeweils für sich digitalisiert und anschließend zur Bildung des Qualitätssignals weiterverarbeitet werden.

Nach einer anderen Ausgestaltung der Erfindung wird das Verfahren nacheinander für mehrere Antennenzweige durchgeführt, um in Abhängigkeit der jeweiligen Qualitätssignale denjenigen Antennenzweig auszuwählen, bei dem die reflektierte Leistung am kleinsten ist.

Insbesondere bei Kraftfahrzeugen sind häufig zwei Antennenanschlußmöglichkeiten vorgesehen, wobei eine Antenne als normale Sende-/Empfangsantenne außen am Fahrzeug angebracht ist, während eine zweite und als Notfallantenne vorgesehene Antenne sich an einem geschützteren Einbauort befindet, z. B. auf der Hutablage oder im Kofferraum. Wird nun bei einem Unfall die außen am Kraftfahrzeug angebrachte Antenne beschädigt oder zerstört, muß von einem mit den Antennenzweigen verbundenen Telefon nach dem Unfall eine Verbindung zur Bastsstation hergestellt werden, um einen Notruf absetzen zu können. Dies kann durch den Fahrer des Kraftfahrzeugs oder durch einen im Kraftfahrzeug vorhandenen und automatisch arbeitenden Notfall-Detektor erfolgen. Für diesen Notruf steht dann derjenige Antennenzweig zur Verfügung, bei dem die geringsten Reflexionen gemessen wurden, also in diesem Fall die Notfallantenne.

Wie bereits oben erwähnt, kann das Ausmessen der jeweiligen Antennenzweige periodisch erfolgen, und zwar in so kurzen Zeitabständen, daß nach einem Unfall und Bruch der normalen Sende-/Empfangsantenne sehr schnell der noch bestehende weitere Antennenzweig zur Absetzung des Notrufs ausgewählt werden kann. Das Auswählen des günstigsten Antennenzweigs kann aber ebenfalls auch auf Veranlassung des Notfall-Detektors erfolgen, nachdem dieser einen Unfall detektiert hat.

Eine erfindungsgemäße Vorrichtung zur Inspektion wenigstens eines Antennenzweigs, insbesondere in einem Fahrzeug, umfaßt: einen HF-Leistungsverstärker zur Einspeisung einer abzustrahlenden Leistung in den Antennenzweig: einen zwischen dem HF-Leistungsverstärker und dem Antennenzweig liegenden bidirektionalen Meßrichtkoppler, der die abzustrahlende Leistung und eine reflektierte Leistung, jeweils um die Koppeldämpfung reduziert, auskoppelt; und eine Auswerteschaltung, die die ausgekoppelte abzustrahlende Leistung und die ausgekoppelte reflektierte Leistung empfängt und in Abhängigkeit davon ein die Güte des Antennenzweigs angebendes Qualitätssignal erzeugt. Dabei kann die Auswerteschaltung eine Beurteilungsstufe aufweisen, die anhand der den jeweiligen Vor- oder Rücklaufleistungen proportionalen Gleichspannungen oder ihrer Digitalwerte das Qualitätssignal bildet.

Bei dem bidirektionalen Meßrichtkoppler handelt es sich um gekoppelte Mikrostreifenleitungen auf einem dielektrischen Substrat. Ein derartiger Meßrichtkoppler ist bereits aus R. K. Hoffmann, "Integrierte Mikrowellenschaltungen", Springer Verlag ISBN 3-540-12352-0 bzw. ISBN 3-387-12352-0 bekannt.

In Weiterbildung der Erfindung ist ein Umschalter vorgesehen, der je nach Schaltstellung den Ausgang des bidirektionalen Meßrichtkopplers mit jeweils einem von mehreren Antennenzweigen verbindet, wobei der Umschalter zur Veränderung seiner Schaltstellung durch die Auswerteschaltung ansteuerbar ist.

Für den Fall, daß lediglich zwei Antennenzweige vorhanden sind und beide keinen Schaden aufweisen, wird einer dieser Antennenzweige nach einem vorgegebenen Algorithmus ausgewählt, z. B. die normale Sende-/Empfangsantenne außen an einem Kraftfahrzeug. Bei mehreren betriebsbereiten Antennenzweigen und nur einem oder mehreren defekten Antennenzweigen wird ein betriebsbereiter Antennenzweig ebenfalls nach einem vorbekannten Algorithmus ausgewählt, wie bereits erwähnt. Ein derartiger Auswahlalgorithmus gehört zum Stand der Technik, so daß auf ihn an dieser Stelle nicht weiter eingegangen zu werden braucht.

Die Erfindung wird nachfolgend unter Bezugnahme auf die Zeichnung im einzelnen erläutert. Es zeigen:
**Figur 1** ein Blockschaltbild eines HF-Systems mit automatischer Antennenzweigauswahl;
**Figur 2** ein Teil des Blockschaltbilds nach Figur 1 mit analoger Qualitätssignalbildung und Unfall-Detektor;
**Figur 3** eine andere Variante der Schaltungsanordnung nach Figur 2 mit digitaler Qualitätssignalbildung;
**Figur 4** ein Ersatzdiagramm eines Meßrichtkopplers für die Schaltungsanordnungen nach den Figuren 1 bis 3, und
**Figur 5** ein Flußdiagramm zur Erläuterung des erfindungsgemäßen Verfahrens.

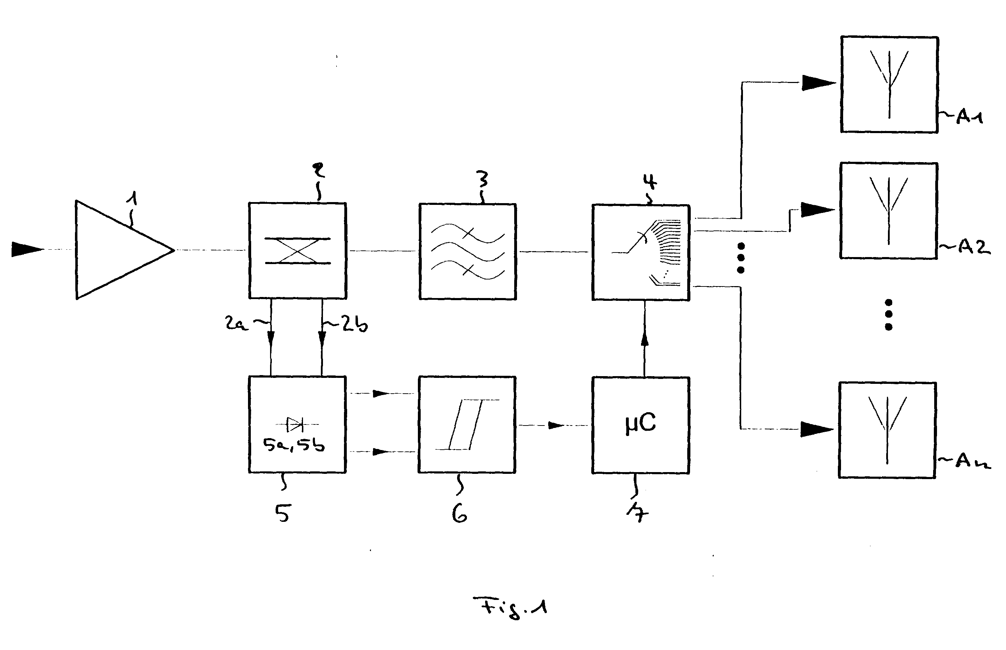

Die Figur 1 zeigt ein Blockschaltbild eines HF-Systems, bei dem eine automatische Umschaltung des Antennenzweigs bzw. der Antenne in Abhängigkeit der Anpassung der Sendeantenne an den Antennenanschluß vorgenommen wird.

Zur Messung der Anpassung der Sendeantenne an den Antennenanschluß ist es nötig, die vorlaufende und die rücklaufende Welle pro Antennenzweig meßtechnisch zu erfassen.

Um dies zu ermöglichen, wird einem Hochfrequenzverstärker 1, der z. B. der Endverstärker eines Mobiltelefons sein kann, ein bidirektionaler Meßrichtkoppler 2 nachgeschaltet, der eine der vorlaufenden Welle und eine der rücklaufenden Welle proportionale Leistung auskoppelt.

Im Sendezweig durchläuft die vom Hochfrequenzverstärker erzeugte Leistung nach Durchlaufen des Meßrichtkopplers 2 ein Bandpaßfilter 3, z. B. den Tx-Filterzweig des Duplexfilters eines GSM-Telefons, und anschließend einen Antennenumschalter 4 zur Selektion eines Antennenzweigs bzw. einer Sendeantenne. Im vorliegenden Fall kann der Ausgang des Duplexfilters 3 über den Antennenumschalter 4 zeitlich nacheinander auf mehrere Antennen A1, A2, ..., An gelegt werden. Die hochfrequente Leistung vom Hochfrequenzverstärker 1 wird schließlich durch eine dieser Sendeantennen A1, A2, ..., An abgestrahlt.

Der Wellenwiderstand einer Antenne muß dabei dem Wellenwiderstand des HF-Systems entsprechen (im allgemeinen 50 Ohm), um die vom Hochfrequenzverstärker 1 erzeugte Leistung optimal abstrahlen zu können. Ist der Wellenwiderstand der Antenne nicht an das System angepaßt, z. B. bei defektem Antennenstecker, Bruch des Antennenkabels oder bei nicht vorhandener Antenne, so wird ein Teil oder sogar die ganze hochfrequente Leistung reflektiert, so daß sie das System in rückwärtiger Richtung durchläuft. Dies führt dazu, daß nur eine reduzierte Leistung über die jeweilige Antenne abgestrahlt werden kann, bis hin zum totalen Leistungsverlust.

Der bidirektionale Meßrichtkoppler 2 ist hier als Vier-Tor ausgebildet. Aufgabe des Meßrichtkopplers 2 ist es, je eine der vorlaufenden Welle und der rücklaufenden Welle proportionale Leistung auszukoppeln. Zu diesem Zweck sind die Ausgänge 2a und 2b vorgesehen.

Die um die Koppeldämpfung reduzierte vorlaufende Welle wird aus dem Meßrichtkoppler über den Ausgang 2a ausgekoppelt, während die um die Koppeldämpfung reduzierte rücklaufende Welle aus dem Meßrichtkoppler über den Ausgang 2b ausgekoppelt wird. Beide Wellen werden zunächst getrennt gleichgerichtet, und zwar in der Gleichrichtereinrichtung 5. Dies führt dazu, daß nach der Gleichrichtung den jeweils ausgekoppelten Leistungen proportionale Gleichspannungen zur Verfügung stehen, die zur Ermittlung z. B. eines Stehwellenverhältnisses VSWR (Voltage Standing Wave Ratio) der jeweiligen Sendeantenne herangezogen werden können. Zur Bildung des Stehwellenverhältnisses dient die Quotienten-Bildungsstufe 6. Die Ermittlung des Stehwellenverhältnisses VSWR kann analog erfolgen und zu einer Information Antenne gut/Antenne schlecht führen (Qualitätssignal).

Eine mit dem Ausgang der Stufe 6 verbundene Steuerung 7 (µ-Computereinheit) übernimmt die Speicherung der Qualitätssignale für die jeweiligen Antennen A1, A2, ..., An (gut/schlecht) und die Steuerung des Antennenumschalters 4 in Abhängigkeit der Qualitätssignale.

Das Fehlen einer Antenne oder das Detektieren einer schlechten bzw. zerbrochenen Antenne führt somit zum unmittelbaren Umschalten des HF-Verstärkers 1 auf eine Antenne mit ausreichender Anpassung. Dabei werden mit "schlecht" beurteilte Antennen unberücksichtigt gelassen, während die restlichen mit "gut" bewerteten Antennen in Übereinstimmung mit einem weiteren Algorithmus bewerten werden, um aus ihnen eine passende Antenne auszuwählen. Auch dies erfolgt mittels der Steuerung 7.

Auf diese Weise wird vermieden, daß z. B. im Falle eines GSM-Systems das Telefon längere Zeit versucht, eine Verbindung aufzubauen, obwohl dieses unmöglich ist, weil die gerade angeschlossene Antenne keine oder nur ungenügende Leistung in den Raum abstrahlen kann. Das System ist somit in der Lage, selbständig und in kürzester Zeit zu erkennen, welche Antenne für den Sendebetrieb geeignet ist und welche nicht. Zu diesem Zweck ist die Steuerung 7 in der Lage, sämtliche Antennen bzw. Antennenzweige der Reihe nach bzw. zyklisch abzutasten bzw. auszumessen.

Da die Meßanordnung ein Senden auf eine schlechte oder nicht vorhandene Antenne verhindert, werden so außerdem Betriebsfälle vermieden, bei denen u. a. der Hochfrequenzverstärker Schaden nehmen (undefinierte Ausgangsanpassung) oder das Senden von Störgrößen (ungewollte Schwingungen) auftreten könnte. Die Lebensdauer, Sicherheit und Zuverlässigkeit des Systems werden somit erhöht. Auch können die Messungen dazu benutzt werden, die ordnungsgemäße Installation (z. B. bei einem Autotelefon) und Funktion des installierten Systems zu überprüfen.

Im Falle eines in einem Kraftfahrzeug installierten Telefons mit Hauptantenne und Notrufantenne kann bei einem automatisch eingeleiteten Notruf, z. B. nach einem Verkehrsunfall, das System ohne Verzögerung eine geeignete Antenne auswählen, um den Notruf absetzen zu können. Sofern die Steuerung 7 nicht sowieso schon permanent bzw. in sehr kurzen Zeitabständen die Überprüfung der Antennen vornimmt, kann sie hierzu von einem Unfalldetektor 8 angesteuert und veranlaßt werden. Über diesen Unfalldetektor 8 kann auch das Telefon automatisch in Betrieb gesetzt werden, sofern hierzu der Benutzer des Kraftfahrzeugs nicht mehr in der Lage sein sollte. Die Figur 2 zeigt den entsprechend weitergebildeten Schaltungsteil aus Figur 1.

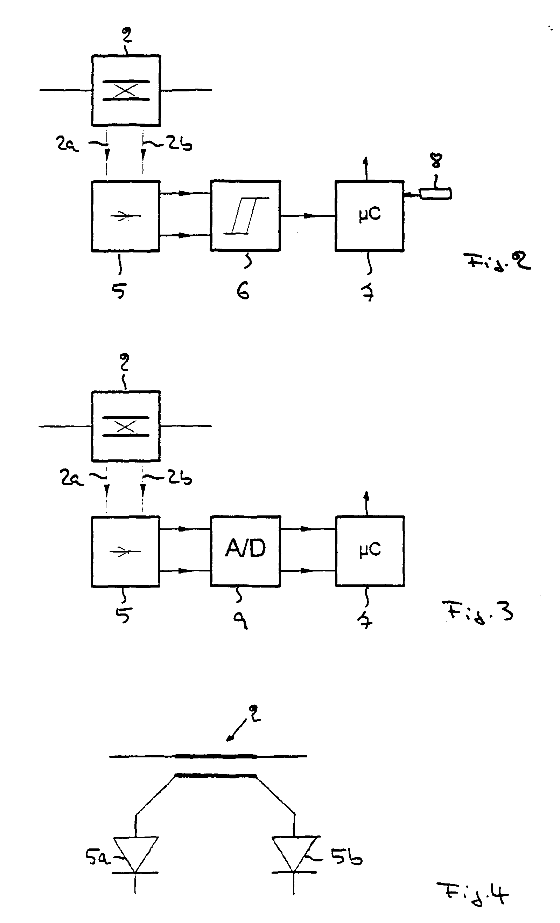

Eine weitere Möglichkeit, das Stehwellenverhältnis VSWR exakt aus den beiden durch die Gleichrichtereinrichtung 5 gelieferten Gleichspannungen zu ermitteln, besteht darin, die beiden Meßwerte zunächst in einem Analog-/Digital-Wandler 9 zu digitalisieren und dann in der µ-Prozessoreinheit 7 zu berechnen. Dies ist in Figur 3 gezeigt. In Abhängigkeit der Größe des berechneten Werts für das Stehwellenverhältnis VSWR kann dann die µ-Prozessoreinheit 7 die Steuerung des Antennenumschalters 4 vornehmen.

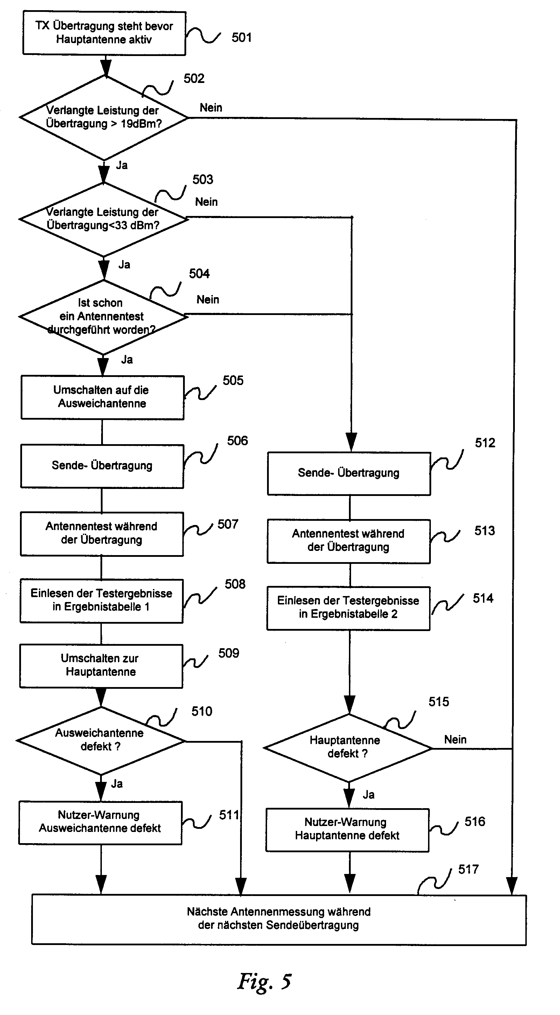

Die Figur 4 zeigt den genauen Aufbau von Meßrichtkoppler 2 und Gleichrichtereinrichtung 5. In bekannter Weise besteht der Meßrichtkoppler 2 aus zwei in enger Nachbarschaft im Abstand nebeneinander laufenden Mikrostreifenleitungen, die sich auf einer Oberfläche eines dielektrischen Substrats befindet, auf dessen anderer Oberfläche eine Massemetallisierung vorhanden ist. Die Mikrostreifenleitungen sind elektromagnetisch miteinander gekoppelt. Eine der Mikrostreifenleitungen, die gerade ausgebildet ist, ist mit ihrem einen Ende mit dem Ausgang des Leitungsverstärkers 1 verbunden und mit ihrem anderen Ende mit dem Eingang des Bandpaßfilters 3. Die andere Mikrostreifenleitung ist mit ihren Enden gegenüber der ersten Mikrostreifenleitung abgebogen, wobei die Enden dieser anderen Mikrostreifenleitung jeweils über eine Diode 5a, 5b mit unterschiedlichen Eingängen der Quotientenbildungsstufe 6 in den Figuren 1 und 2 oder mit unterschiedlichen Eingängen des Analog-/Digitalwandlers 9 in Figur 3 verbunden sind. Statt der Dioden 5a, 5b können auch jeweils zu Dioden geschaltete Transistoren zum Einsatz kommen.

Die Erfindung könnte z. B. eingesetzt werden in Autotelefonen, Funktelefonen, Funkgeräten, Rundfunksendeanlagen, Antennenanlagen in Fahrzeugen und Gebäuden, und dergleichen.

Anhand des Ablaufdiagramms in Figur 5 wird eine Anwendung der Erfindung, wie sie beispielsweise im zellularen GSM-System (Global System for Mobile Communication) durchgeführt werden könnte, beschrieben.

Bei diesem Ablaufdiagramm wird vorausgesetzt, daß ein Autotelefon (Mobilstation) mit einer Hauptantenne, welche außen am Fahrzeug angebracht ist, und einer Ausweichantenne ausgestattet ist. Die Ausweichantenne ist nur in einem Notfall in Betrieb zu nehmen, beispielsweise wenn bei einem Unfall die Hauptantenne beschädigt wurde.

Im Schritt 501 steht die Übertragung eines Signals von der Mobilstation zu der Basisstation innerhalb des zellularen Mobiltelefonnetzes bevor. Die Hauptantenne der Mobilstation ist eingeschaltet.

Wie in zellularen Netzen üblich, wird die Sendeleistung der Mobilstation von der Basisstation vorgegeben, um auch bei minimaler Sendeleistung noch eine gute Übertragungsqualität zu erreichen.

Da wegen der Koppelstruktur für die rücklaufende Welle und der signalführenden Microstrip-Leiterbahn eine Koppeldämpfung besteht, ist die Messung der rücklaufenden Welle auf bestimmte Leistungsbereiche eingeschränkt. Aus diesem Grund wird in Schritt 502 zunächst abgefragt, ob die von der Basisstation verlangte Sendeleistung > 19 dBm (79 mW) ist. Ist dies nicht der Fall, kann keine Antennenmessung durchgeführt werden und es wird in Schritt 517 verzweigt.

Um innerhalb des Fahrzeuges keine Hochfrequenzstrahlung, die einen Maximalwert überschreitet, während des Antennentests auszustrahlen, wird der Antennentest der im Fahrzeuginnenraum befindlichen Ausweichantenne ab einer bestimmten Sendeleistung nicht durchgeführt. Deshalb wird in Schritt 503 abgefragt, ob die verlangte Sendeleistung einen vorgegebenen Wert überschreitet, dies sind hier 33 dBm = 2 Watt.

Wenn dieser Wert überschritten wird, kann nur ein Antennentest für die Hauptantenne durchgeführt werden und es wird zu Schritt 512 verzweigt.

Falls nach dem Einschalten der Mobilstation noch kein Antennentest durchgeführt wurde, ist vorrangig ein Test der Hauptantenne durchzuführen. Deshalb wird in Schritt 504 abgefragt, ob bereits ein Antennentest durchgeführt wurde. Ist dies nicht der Fall, wird zu Schritt 512 verzweigt, um einen Test der Hauptantenne durchzuführen.

Befindet sich die vorgegebene Sendeleistung im Bereich zwischen der minimalen und maximalen Sendeleistung für eine Messung der Ausweichantenne und wurde die Hauptantenne bereits getestet, ist ein Test der Ausweichantenne möglich und in Schritt 505 wird auf die Ausweichantenne umgeschaltet.

Im Schritt 506 startet die Sende-Übertragung über die Ausweichantenne und in Schritt 507 wird der Antennentest während der Sendeübertragung durchgeführt. Der Antennentest kann beispielsweise gleich zu Beginn bei der Übertragung des RACH (Random Access Channels) durchgeführt werden, mit dem die Mobilstation sich bei der Basisstation anmeldet und einen Kanal für ein Gespräch anfordert.

Im Schritt 507 wird gleichzeitig die reflektierte Leistung detektiert und ausgewertet. Das Ergebnis des Antennentests wird im Schritt 508 in die Ergebnistabelle 1 eingetragen.

Um eine unnötige Verwendung der Ausweichantenne zu verhindern, wird nach Beendigung des Antennentests der Ausweichantenne in Schritt 510 unmittelbar wieder auf die Hauptantenne umgeschaltet.

Ist das Ergebnis des Testens der Ausweichantenne, daß sie in Ordnung ist, wird in in Schritt 517 verzweigt.

Sollte sich herausstellen, daß die Ausweichantenne den Anforderungen nicht genügt, wird dem Anwender in Schritt 511 zum Beispiel über das Display des Mobiltelefons angezeigt, daß die Ausweichantenne defekt ist.

Der Test der Hauptantenne wird in den Schritten 512 - 514 analog zu dem Test der Ausweichantenne durchgeführt. Da die Hauptantenne, wie oben beschrieben, zunächst grundsätzlich eingeschaltet ist, braucht hier nicht erst zur Hauptantenne umgeschaltet werden. Das Ergebnis des Hauptantennen-Tests wird im Schritt 514 in die Ergebnistabelle 2 eingetragen.

Im Schritt 516 wird das Ergebnis der Messung aus der Ergebnistabelle 2 abgefragt. Wird ein Defekt der Hauptantenne festgestellt, dann wird dies dem Anwender in Schritt 516 mitgeteilt.

Wurde kein Defekt an der Hauptantenne festgestellt, wird zu Schritt 517 verzweigt und bei der nächsten Sendeübertragung der Testablauf erneut gestartet.

Der Vorteil des in diesem Ablaufdiagramm beschriebenen Verfahrens besteht insbesondere darin, daß die Antennenmessungen während des normalen Betriebs der Mobilstation innerhalb des zellularen Mobilfunksystems durchgeführt werden können, ohne durch nicht standardkonforme Aussendung von Signalen das Mobilfunksystem zu stören.

## Patentansprüche

1. Verfahren zur Inspektion wenigstens eines Antennenzweigs, insbesondere in einem Fahrzeug, mit folgenden Schritten:
- in den Antennenzweig wird eine abzustrahlende Leistung eingespeist;
- eine im Antennenzweig reflektierte Leistung wird erfaßt; und
- es werden die eingespeiste Leistung und die reflektierte Leistung zueinander in Beziehung gesetzt, um ein die Güte des Antennenzweigs angebendes Qualitätssignal zu erhalten.

2. Verfahren nach Anspruch 1, **dadurch gekennzeichnet,** daß zur Bildung des Qualitätssignals die eingespeiste Leistung und die reflektierte Leistung zueinander ins Verhältnis gesetzt werden.

3. Verfahren nach Anspruch 1 oder 2, **dadurch gekennzeichnet**, daß die abzustrahlende Leistung und die reflektierte Leistung mit Hilfe eines im Antennenzweig vorhandenen bidirektionalen Meßrichtkopplers (2) erfaßt werden.

4. Verfahren nach Anspruch 3, **dadurch gekennzeichnet**, daß der erfaßte abzustrahlende Leistungswert und der erfaßte reflektierte Leistungswert zur Bildung des Qualitätssignals digitalisiert werden.

5. Verfahren nach einen der Ansprüche 1 bis 4, **dadurch gekennzeichnet**, daß es nacheinander für mehrere Antennenzweige durchgeführt wird, um in Abhängigkeit der jeweiligen Qualitätssignale denjenigen Antennenzweig auszuwählen, bei dem die reflektierte Leistung am kleinsten ist.

6. Verfahren nach einem der Ansprüche 1 bis 5, **dadurch gekennzeichnet,** daß es unter Verwendung einer Mobilstation durchgeführt wird, mit der der wenigstens eine Antennenzweig verbunden ist.

7. Verfahren nach Anspruch 6, **dadurch gekennzeichnet,** daß als Mobilstation ein Autotelefon oder ein tragbares Mobiltelefon (Handy) zum Einsatz kommen.

8. Verfahren nach einem der Ansprüche 5 bis 7, **dadurch gekennzeichnet,** daß die Mobilstation mit einer außen am Fahrzeug angebrachten Hauptantenne und einer im Fahrzeug angebrachten Ausweichantenne verbunden ist.

9. Verfahren nach Anspruch 8, **dadurch gekennzeichnet,** daß für den Fall, daß die Sendeleistung der Mobilstation unterhalb eines ersten vorbestimmten Werts liegt, keine Messung der reflektierten Leistung erfolgt.

10. Verfahren nach Anspruch 8 oder 9, **dadurch gekennzeichnet,** daß für den Fall, daß die Sendeleistung oberhalb eines vorbestimmten zweiten Werts liegt, der größer ist als der vorbestimmte erste Wert, keine Messung der von der Ausweichantenne reflektierten Leistung erfolgt.

11. Verfahren nach einem der Ansprüche 6 bis 10, **dadurch gekennzeichnet,** daß nach dem Einschalten der Mobilstation zunächst die von der Hauptantenne reflektierte Leistung gemessen wird.

12. Verfahren nach einem der Ansprüche 1 bis 11, **dadurch gekennzeichnet,** daß die Inspektion während einer Sendeübertragung durchgeführt wird.

13. Verfahren nach Anspruch 12, **dadurch gekennzeichnet,** daß die Inspektion zu Beginn bei der Übertragung eines RACH's (Random Access Channel) durchgeführt wird.

14. Vorrichtung zur Inspektion wenigstens eines Antennenzweigs, inbesondere in einem Fahrzeug, mit:
- einem HF-Leistungsverstärker (1) zur Einspeisung einer abzustrahlenden Leistung in den Antennenzweig;
- einem zwischen dem HF-Leistungsverstärker (1) und dem Antennenzweig liegenden bidirektionalen Meßrichtkoppler (2), der die abzustrahlende Leistung und eine reflektierte Leistung, jeweils um die Koppeldämpfung reduziert, auskoppelt; und
- einer Auswerteschaltung (5, 6, 7), die die ausgekoppelte reflektierte Leistung empfängt und in Abhängigkeit davon ein die Güte des Antennenzweigs angebendes Qualitätssignal erzeugt.

15. Vorrichtung nach Anspruch 14, **dadurch gekennzeichnet**, daß die Auswerteschaltung Gleichrichter (5a, 6b) aufweist, um ausgekoppelte abzustrahlende und ausgekoppelte reflektierte Wellen jeweils gleichzurichten.

16. Vorrichtung nach Anspruch 15, dadurch gekennzeichnet, daß die Auswerteschaltung A/D-Wandler (9) aufweist, um den jeweiligen Vor- oder Rücklaufleistungen proportionale Gleichspannungen zu digitalisieren.

17. Vorrichtung nach Anspruch 15 oder 16, dadurch gekennzeichnet, daß die Auswerteschaltung eine Beurteilungsstufe (7) aufweist, die anhand der den jeweiligen Vor- oder Rücklaufleistungen proportionalen Gleichspannungen oder ihrer Digitalwerte das Qualitätssignal erzeugt.

18. Vorrichtung nach einem der Ansprüche 14 bis 17, gekennzeichnet durch einen Umschalter (4), der je nach Schaltstellung den Ausgang des bidirektionalen Meßrichtkopplers (2) mit jeweils einem von mehreren Antennenzweigen (A1, A2, ..., An) verbindet, wobei der Umschalter (4) zur Veränderung seiner Schaltstellung durch die Auswerteschaltung ansteuerbarist.
